# EUROPEAN PATENT APPLICATION

(11) **EP 1 018 801 A2**
(43) Date of publication of application: **12.07.2000**
(21) Application number: 00100103.1
(22) Date of filing: 04.01.2000
(51) Int. Cl.: H03F 3/21, H03F 3/193

(54) **Advanced amplifier, transmission unit and cellular telephone using the same**

(30) Priority: 08.01.1999 JP 296299
(71) Applicant: NEC CORPORATION, Tokyo (JP)
(72) Inventor: Fujita, Masanori, Minato-ku, Tokyo (JP)
(74) Representative: Glawe, Delfs, Moll & Partner

(57) **Abstract**

An advanced amplifier, according to the present invention, is comprised of FETs (field-effect transistors) 14 and 15 with the respective different threshold voltages, an input impedance matching circuit 12, coupling condensers C1 and C2, and an output impedance matching circuit 13. Controlling the operation of the FETs 14 and 15 in the following manner can provide a highly operational efficiency. That is, in order for the FETs 14 and 15 to output their maximum power, a gate bias voltage (V_{GG}) is applied to the their common gate so that the FETs 14 and 15 can operate in the vicinity of the saturated output level, which is decided by the total gate width of the FETs 14 and 15. On the other hand, in order for the FETs 14 and 15 to output a small power, a controlled gate bias voltage (V_{GG}) is applied to the common gate so that only the FET1, for example, can be activated in order for it to operate in the vicinity of the saturated output level, which is decided by the gate width of the FET1. As a result, the advanced amplifier according to the present invention can operate with a higher operational efficiency than that of the conventional amplifiers where the FETs are both activated at the same time. The impedance matching circuit 12 receives a signal 120, impedance-matches, and then outputs its resulting signal to FETs 14 and 15 via the coupling condenser C1. The FETs 14 and 15 then amplify the resultant signal in the aforementioned manner, thus outputting its resulting amplified signal to the impedance matching circuit 13 via the coupling condenser C2. A drain bias voltage V_{DD} is supplied to either drain of the FETs 14 and 15.

## Description

### BACKGROUND OF THE INVENTION

### Field of the Invention

The present invention relates to an advanced amplifier, a transmission unit and cellular telephone using the same.

### Description of the Related Art

Japanese Patent Application Laid-open No. Sho 57-60739 discloses a conventional amplifier with an improved operating efficiency when outputting a low power level. This amplifier is comprised of a transmission device, which automatically selects an optimal one from the pre-established multiple output impedance matching circuits so as to maximize the operational efficiency. This apparatus is made up of a controller that generates a signal used to changeover the output impedance matching circuits, an optimal value decision circuit that selects the optimal output impedance matching circuit and transmits a signal to its matching changeover circuit, and a PIN (p-type, intrinsic, n-type) diode that is used to changeover the multiple output matching circuits and is commonly used in wireless communication systems.

In this apparatus, the PIN diode used for switching the output impedance matching circuits, is always biased so that all of the output impedance matching circuits can be successively switched. In other words, it is necessary to have an electric current of several milliamperes (mA) flowing through the PIN diode at all times. Two PIN diodes are needed for each output impedance matching circuit. In other words, if there are n output impedance matching circuits, (2 x n) PIN diodes are necessary. As a result, supposing that a single PIN diode consumes an electric current of 1 mA, a consumed current of (n x 2) mA would constantly flow.

According to the conventional amplifier described in the above Japanese Patent Application Laid-open No. Sho 57-60739, the output impedance matching circuits are changed over. However, since there is no change in the size of the transistors used for the amplifier, an improvement in the operational efficiency at the time of outputting a low power level cannot be expected.

Also, since the changeover PIN diode is in a continuous state of current flow, a problem arises in that the current consumption cannot be decreased.

Furthermore, according to the above-mentioned Japanese Patent Application Laid-open No. Sho 57-60739, in order to improve the operational efficiency, an optimal pre-established multiple output impedance matching circuit is automatically selected. Through this operational step, even though an optimal output impedance matching circuit is selected depending upon the output power level, the actual operating amplifier (transistors) itself is not changed. Thus, if it is used for actual wireless communication systems, an improvement in the operational efficiency cannot be expected within the range 10 to 30 dB below the maximum output level.

This problem emanates from the fact that when large-sized transistors, which are needed so as to output a certain maximum power level, operate and output power levels 10 dB to 30 dB lower than their maximum power level, the operational efficiency drops more than in the case where optimally-sized transistors are used to amplify, even though optimal impedance matching circuits are used to impedance-match.

The following points (1) ∼ (4) are examples of the main reasons for this problem.
(1) A perfect match cannot be made due to the low impedance of the transistor element.
(2) The amount of transmission loss by the impedance matching circuit, which impedance-matches to this low impedance, increases.
(3) Since the large-sized transistors are each generally made up of multiple unit cells that are connected parallel to one another, when the operating characteristics of each unit cell differ and coupling loss between adjacent unit cells occurs, a certain expected operational efficiency of the transistors cannot be obtained.
(4) The large-sized transistor has a lower power gain than that of optimally-sized transistors that are designed to output a low power level.

It is plain to see that when compared, the operational efficiency of a transistor optimally-sized to output a low power level is advantageous over a large-sized transistor that is operated 10 dB to 30 dB lower than its maximum output level.

Actually, the amplifier mentioned in the above Japanese Patent Application Laid-open No. Sho 57-60739 is not useful in solving these problems.

Since the size is fixed for the transistors arranged at the very end, only the switching of the output impedance matching circuits dependent upon their necessary output power level is unable to maintain its expected operational efficiency. As a result, the operational efficiency drops below 10% at the time of outputting a power level of approximately +10 dBm.

Furthermore, the PIN diode, which is used as a means for switching the output impedance matching circuits as described above, is required to be always biased to have several milliamperes of constant current flow so that all of the output impedance matching circuits can be successively switched.

The number of necessary PIN diodes per output impedance matching circuit is two. In other words, if there are n output impedance matching circuits, (2 x n) PIN diodes are necessary. In this case, supposing that one PIN diode consumes an electric current of 1 mA, total current of (n x 2) mA always flows.

Since this current always flows unrelated to the output power level, this is a serious problem within mobile telephone systems that strongly demand a decrease in power consumption.

Moreover, Japanese Patent Application Laid-open No. Hei 10-79629 discloses a power amplifier structured with multiple FETs (field-effect transistors) in a paralleled connection. With this structure, adjusted, independent gate voltages are applied to the respective gate terminals of the FETs so that the drain current of the power amplifier can be adjusted.

According to the above patent gazette, it is possible to adjust each of the gate biases of the FETs in small steps. This enables an improvement in the working efficiency at the time of adjusting the gate biases of the power amplifiers in a manufacturing line, etc.

### SUMMARY OF THE INVENTION

In view of the above problems, an objective of the present invention is to provide an advanced amplifier, which can operate with a high operational efficiency even when outputting a low power level.

Furthermore, an objective of the present invention is to provide a transmission unit, comprised of the said advanced amplifier, which can operate with a high operational efficiency in conformity with an external control signal.

Furthermore, an objective of the present invention is to provide a cellular telephone, comprised of the said transmission unit, which can operate with high operational efficiency.

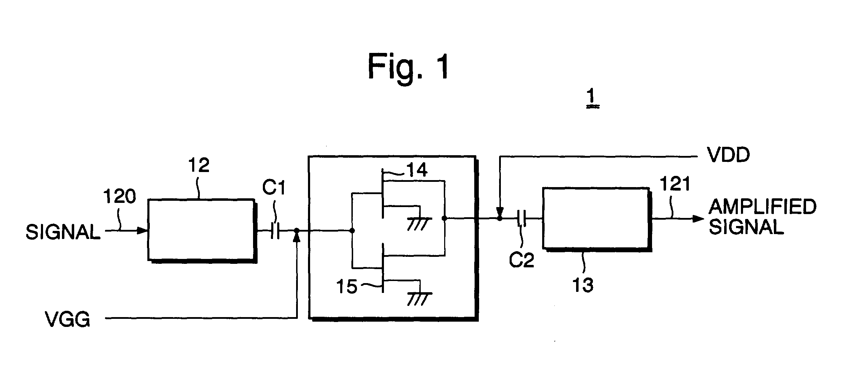

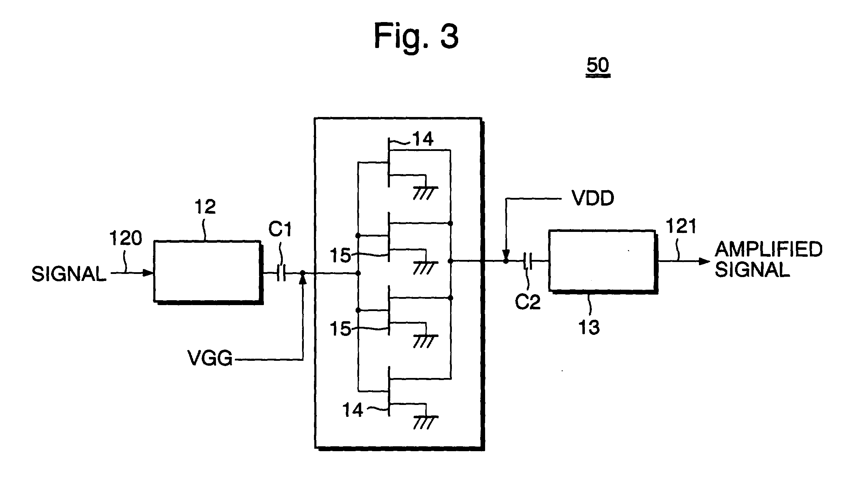

According to an aspect of the present invention, an advanced amplifier is provided, and is comprised of a first transistor (14) with a first threshold; and a second transistor (15) with a second threshold that is different from the said first threshold, and also with its control electrode being connected to the control electrode of the said first transistor. An example of the advanced amplifier as described above is illustrated in Figs. 1 and 3.

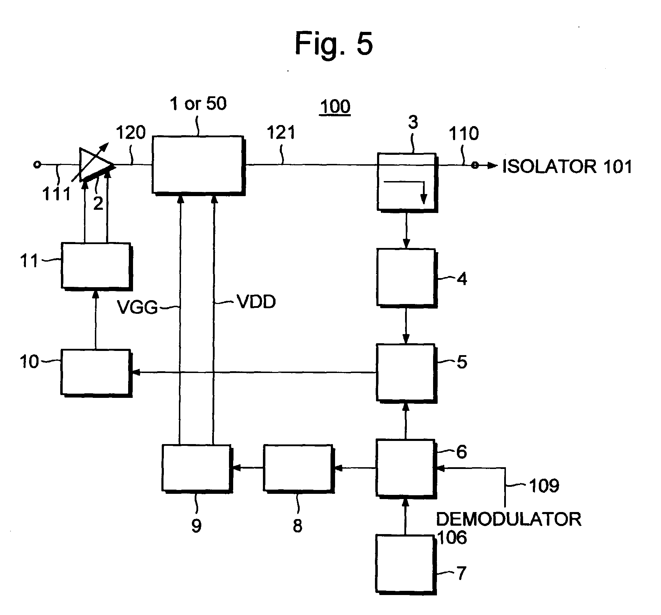

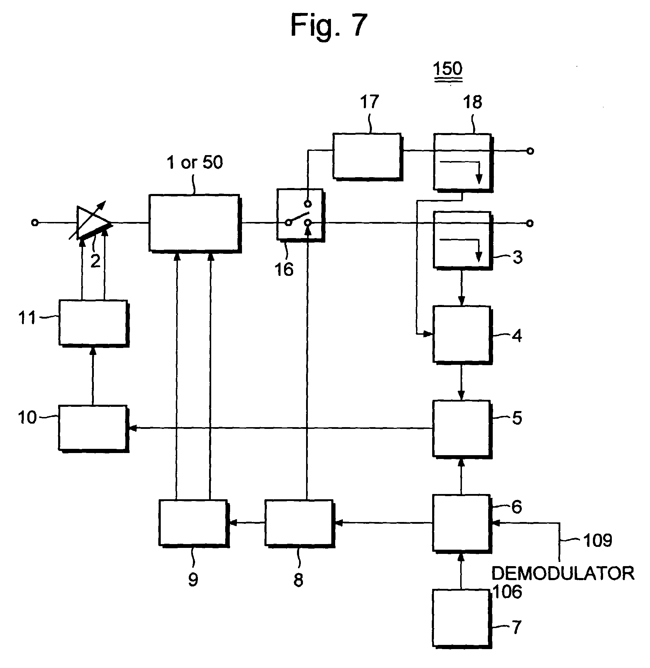

According to an aspect of the present invention, a transmission unit, which amplifies a signal and transmits it, is provided, and is comprised of an amplifier (1), which is comprised of a first transistor (14) with a first threshold and a second transistor (15) with a second threshold that is different from the said first threshold and also with its control electrode being connected to the control electrode of the said first transistor; and a controller (6, 7, 8, 9), which gives the control electrodes of the said first and second transistors a control signal (VGG) dependent upon a reception signal (109). An example of the transmission unit as described above is illustrated in Figs. 5 and 7.

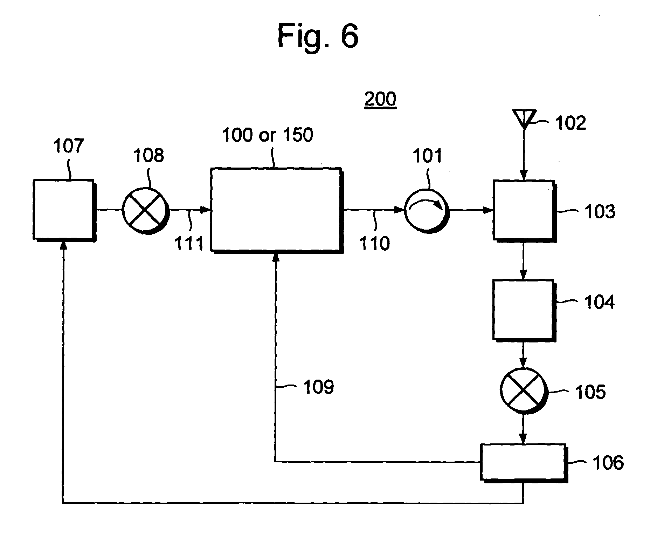

According to an aspect of the present invention, a cellular telephone, is provided, and is comprised of a reception unit (102, 103, 104, 105, 106), which receives a signal and measures its strength (109); an amplifier (1), which is comprised of a first transistor (14) with a first threshold and a second transistor (15) with a second threshold that is different from the said first threshold and also with its control electrode being connected to the control electrode of the said first transistor; and a controller (6, 7, 8, 9), which gives the control electrodes of the said first and second transistors a control signal (V_{GG}) dependent upon the said strength (109). An example of the cellular telephone as described above is illustrated in Fig. 6.

### BRIEF DESCRIPTION OF DRAWINGS

The above and other objects, features and advantages of the present invention will become more apparent from the following detailed description, when taken in conjunction with the accompanying drawings, wherein:
Fig. 1 illustrates an advanced amplifier, according to the first embodiment of the present invention;
Fig. 2 is a graph showing the relationship between V_{GG} and I_{DD} of the FETs;
Fig. 3 illustrates an advanced amplifier, according to the second embodiment of the present invention;
Fig. 4 is a graph showing the relationship between the operational efficiency and output power of the FETs;
Fig. 5 illustrates a signal transmission circuit comprised of the advanced amplifier, according to the third embodiment of the present invention;
Fig. 6 illustrates a signal transmission circuit comprised of the advanced amplifier, according to the fourth embodiment of the present invention; and
Fig. 7 illustrates an outline of a cellular telephone, comprised of the signal transmission circuit, according to the present invention.

### DETAILED DESCRIPTION OF THE PREFERRED EMBODIMENT

### (First embodiment)

An advanced amplifier, according to the first embodiment of the present invention, will be described while referencing Fig. 1. Fig. 1 illustrates the configuration of the advanced amplifier of the first embodiment. In this figure, the advanced amplifier is comprised of FETs (field-effect transistors) 14 and 15 with their respective different threshold voltages, an input impedance matching circuit 12, coupling condensers C1 and C2, and an output impedance matching circuit 13. Controlling the operation of the FETs 14 and 15 in the following manner can provide a high operational efficiency. That is, in order for the FETs 14 and 15 to output their maximum power, a gate bias voltage (V_{GG}) is applied to their common gate so that the FETs 14 and 15 can operate in the vicinity of the saturated output level, which is decided by the total gate width of the FETs 14 and 15. On the other hand, in order for the FETs 14 and 15 to have a low power output, V_{GG} is applied to the common gate so that only the FET1, for example, can be activated in order to operate in the vicinity of the saturated output level decided by the gate width of the FET1. As a result, the advanced amplifier, according to the present invention, can operate with a higher operational efficiency than that of the conventional amplifiers where both FETs are activated at the same time.

The impedance matching circuit 12 receives a signal 120, matches the impedance, and then outputs its resulting signal to FETs 14 and 15 via the coupling condenser C1. The FETs 14 and 15 then amplify the resultant signal in the aforementioned manner, thus outputting the resulting amplified signal to the impedance matching circuit 13 via the coupling condenser C2. A drain bias voltage (V_{DD}) is supplied to either drain of the FETs 14 and 15.

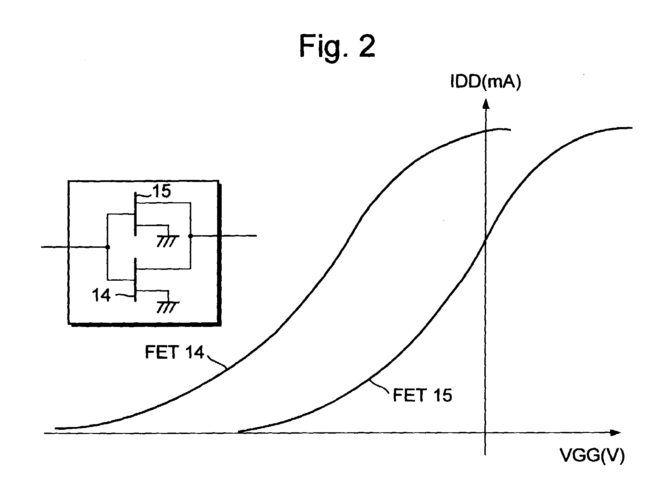

Fig. 2 is a graph showing the relationship between the gate bias voltage and the current (I_{DD}) applied to the FETs 14 and 15 in the advanced amplifier.

The operation of the FETs 14 and 15 under the following conditions and arrangement will be described while referencing Fig. 2. Namely, the conditions when the threshold voltages of the FETs 14 and 15 are equal to, for example, - 0.5 V and - 1.0 V respectively; the FETs 14 and 15 are connected parallel to each other; the source electrodes of the FETs 14 and 15 are both grounded; their gate electrodes are connected to each other; their drain electrodes are also connected to each other; and the input impedance matching circuit 12 and output impedance matching circuit 13 give their respective input and output lines an equivalent impedance of 50Ω.

Both FET 14 and FET 15 are driven by a gate bias voltage equal to - 0.5 V or greater so that they can output a signal in the vicinity of the maximum output level.

In the case where the cellular telephone is located near a base station, in order for the advanced amplifier to output a low level signal, an optimum gate bias voltage ranging from - 0.5 V to - 1.0 V is applied to the FETs 14 and 15. As a result, the FET 15 turns on, but the FET 14 turns off at the same time.

The gate bias voltage is stored in a memory unit (e.g., ROM 7, which will be described later in reference to Fig. 5) in advance, in the format such that the gate bias voltage is linked to the output power level.

### (Second embodiment)

Next, an advanced amplifier 50, according to the second embodiment of the present invention, will be described while referencing Fig. 3. It is noted that the same functional elements as those in Fig. 1 are assigned the same reference numeral in this figure.

The advanced amplifier 50 in Fig. 3 is comprised of two FETs 14 and two FETs 15 (the tour being connected parallel to one another and which also have identical threshold voltages to those of the first embodiment), an input impedance matching circuit 12, coupling condensers C1 and C2, and an output impedance matching circuit 13. It is preferable that each of the FETs have output characteristics corresponding to its application system (e.g., a circuit as shown in Fig. 5 which is described later), and that the pinch-off voltages of the FETs fall within the range of the supply voltages that the application system (see PA power supply 9 in Fig. 5 which is detailed later) can supply.

Also, it is preferable, considering the possible adverse affect caused by inharmonic operations of the respective FETs, which are connected parallel to one another, that each of the FETs are symmetrically lined in terms of the difference between the two threshold voltages. That is, they are lined in the order of FET 14, FET 15, FET 15, and FET 14, with their gate electrodes being connected to one another and with their drain electrodes being connected to one another.

The impedance matching circuits 12 and 13 are designed for the purpose of maximizing the operational efficiency while satisfying an allowable signal distortion. Furthermore, in the case where an FM signal, or another type of signal such as a GMSK (Guassian minimum shift keying) modulated signal enters the advanced amplifier 50, the input and output lines of the impedance matching circuits need to be impedance-matched to a characteristic impedance of 50Ω. Incidentally, the operational efficiency is defined by Pₒᵤₜ (dBm) / V_{DD} (V) * I_{DD} (mA), where Pₒᵤₜ denotes the output power level of the advanced amplifier 50 (or 1 in Fig. 1).

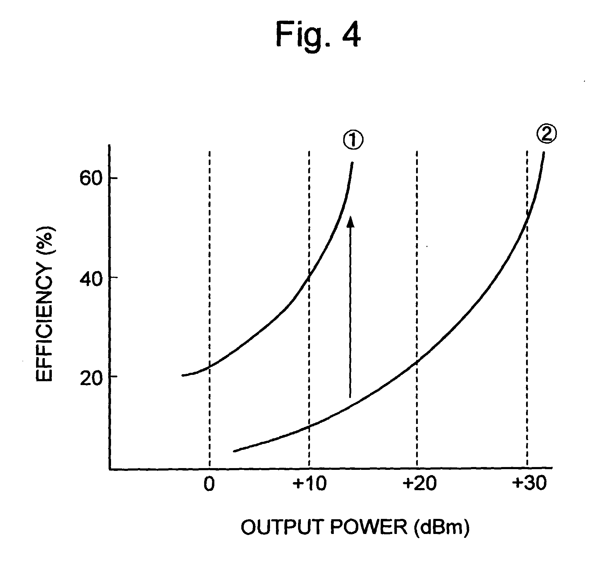

Fig. 4 illustrates the relationship between the output power of an amplifier and its operational efficiency. In Fig. 4, curve ② shows the characteristics of the conventional amplifier, under the following conditions: the gate bias voltage V_{GG} is fixed to be a certain voltage and two different threshold voltages of FETs 14 and 15 are used. That is, when the maximum output is equal to + 30 dBm (its corresponding operational efficiency being equal to approximately 60%), a decrease in the output level to + 20 dBm causes the operational efficiency to drop to approximately 20% as shown by curve ② in Fig. 5.

On the other hand, curve ① in Fig. 4 shows the characteristics of the advanced amplifier 50 made up of two different threshold voltages of FETs 14 and 15, according to the present invention, in the format where only FET 14 has been activated. In this case, the output power level goes down, and the maximum output is equal to a value ranging from + 12 dBm to + 13dBm. The operational efficiency is equal to approximately 60 %, accordingly. To be precise, the operational efficiency of the advanced amplifier 50, according to the present invention, is controlled to be approximately 60% in conformity with an optimally applied gate bias voltage V_{GG}.

### (Third embodiment)

Next, a transmission circuit 100 in a wireless communication system, comprised of the advanced amplifier 1 (or 50) as described above, according to a third embodiment of the present invention, will be described while referencing Fig. 5.

In Fig. 5, a modulated transmission signal enters a variable gain amplifier 2. An AGC/power supply 11, which is controlled by a variable gain/voltage control circuit 10, supplies the variable gain amplifier 2 with controlled electric power in order for the variable gain amplifier 2 to change its own on/off status and level of gains. The signal amplified by the variable gain amplifier 2 enters the advanced amplifier 1, which then amplifies and outputs its resulting signal to a directional coupler 3 via a transmission line 121. The directional coupler 3 also outputs a part being approximately one one-hundredth (10⁻²) of the resultant signal coming from the advanced amplifier 1, to a wave detector 4. The wave detector 4 converts part of the signal into a corresponding DC voltage, thus outputting it to a comparator 5.

A controller 6 receives a signal 109 that indicates the distance from the base station. It then reads out control information corresponding to the received signal, from the ROM (Read Only Memory) 7, and outputs the resulting control signal dependent on the read-out control information, to the comparator 5 and a voltage control circuit 8. The comparator 5 compares the control signal to the above-mentioned part of the signal, and outputs the resulting error signal to a variable gain/voltage control circuit 10. The variable gain/voltage control circuit 10 generates an AGC (Automatic Gain control) power supply control signal in conformity with the error signal, thus outputting it to an AGC power supply 11. The AGC power supply 11 then supplies the variable gain amplifier 2 with a specific AGC voltage in conformity with the resultant AGC power supply control signal. As a result, the output power level of the variable gain amplifier 2, which is to be supplied to the advanced amplifier 1, can be suitably adjusted.

Upon reception of the control signal from the controller 6, the voltage control circuit 8 controls a PA (Power Amplifier) power supply 9 in order to apply a certain gate bias voltage V_{GG} and drain bias voltage V_{DD} to the advanced amplifier 1.

Next, the operation of the transmission circuit in Fig. 5, according to the third embodiment of the present invention, will be described. In the case where the cellular telephone that uses the transmission circuit is located far from a base station, the controller 6, on reception of a signal 109 that indicates the distance from a base station, reads out a piece of control information, which corresponds to the received signal, from the ROM 7, and then outputs a resulting control signal to the voltage control circuit 8 and comparator 5. The signal that indicates the distance from a base station is, for example, a RSSI (receive signal strength indicator) output signal that is transmitted from a demodulator 106, which is described later with reference to Fig. 6. The control information, which corresponds to the RSSI output signal and is stored in the ROM 7, is used to set the output power level of the advanced amplifier 1 (or 50).

On reception of the control signal from the controller 6, the voltage control circuit 8 accordingly controls the PA power supply 9 to apply a specific gate bias voltage V_{GG} and drain bias voltage V_{DD} to the advanced amplifier 1. In the case of outputting the maximum power level, the PA power supply 9 gives the advanced amplifier 1 a gate bias voltage V_{GG}, which causes all the FETs in the advanced amplifier 1 to be simultaneously activated.

The directional coupler 3 outputs a part being approximately one one-hundredth (10⁻²) of the signal coming from the advanced amplifier 1, to the wave detector 4. The wave detector 4 converts the part of the signal into a corresponding DC voltage, thus outputting it to the comparator 5. The comparator 5 compares the voltage transmitted from the controller 6 to the voltage transmitted from the wave detector 4, thus outputting the resulting error signal or corrective signal to the variable gain/voltage control circuit 10 for the purpose of decreasing the error in the end.

The variable gain/voltage control circuit 10 generates an AGC power supply control signal corresponding to the corrective signal described above, and outputs it to the AGC power supply 11. The AGC power supply 11 then supplies the variable gain amplifier 2 with an AGC voltage corresponding to the resultant AGC power supply control signal. As a result, the output power level of the variable gain amplifier 2, which is to be given to the advanced amplifier 1, can be suitably adjusted

With the operation described above, the controller 6 plays a role in setting the output power level of the advanced amplifier 1 to an optimum value. This type of control is called an APC (Automatic Power Control) system.

With the circuit arrangement described above, a transmission signal can be optimally amplified and output to the directional coupler 3, with the assistance of the feedback routes: the wave detector 4, comparator 5, controller 6, voltage control circuit 8, and then PA power supply 9; the wave detector 4, comparator 5, variable gain/voltage control circuit 10, and then AGC power supply 11.

In the case where the cellular telephone approaches a base station, the gain of the variable gain amplifier 2 is accordingly decreased so as also to decrease the output power level of the advanced amplifier 1. At this time, the operational efficiency of the advanced amplifier 1 goes down compared to the maximum output level.

According to the transmission circuit 100 in Fig. 5, the operational efficiency of the advanced amplifier 1 is equal to approximately 60% as shown by the curve ① in Fig. 4, when the control information for setting the output power level at the directional coupler 3 to a value ranging from + 12 dBm to + 13 dBm, is read out from the ROM 7. In this case, the applying of a certain gate bias voltage V_{GG} corresponding to the above-mentioned control information allows only the FET 15 to be turned off. On the other hand, with the conventional amplifier, as shown by the curve ② in Fig. 4, the operational efficiency goes down to approximately 10 %.

The decibel (dB) -based intervals of the gate bias voltages V_{GG}, which decide the output power levels of the advanced amplifier 1, can be optimally set to be within the dynamic range of the output power.

The control information is stored in the ROM 7 in advance. The APC for a fixed number of FETs in the advanced amplifier 1 is executed by the variable gain/voltage control circuit 10 by changing the gain of the variable gain amplifier 2.

It is preferable that the changeover/activation control of the Jets by applying the gate bias voltage V_{GG} is given a higher priority than the APC. That is, after the changeover/activation control is performed, the APC should be performed.

Furthermore, in the case where the transistors comprising the advanced amplifier, according to the present invention, needs a specific order of applying their individual biases, a sequential order control to satisfy the priority should be used for the advanced amplifier. For example, in the case where the transistors are FETs, the priority is that the gate bias voltage V_{GG} should be applied first, before the drain bias voltage V_{DD} is done.

The advanced amplifier, according to the present invention, can be naturally used for conventional wireless communication systems, only by adding several elements: a controller (which can be assisted by a control program) for changing the operational modes of the FETs and a memory unit that is stored with control information as described above.

Furthermore, the above description explains that the advanced amplifier, according to the present invention, is comprised of two different thresholds of FETs. However, the present invention is not limited to this configuration. Naturally, using more than two different threshold voltages of FETs for the advanced amplifier is also possible.

Furthermore, if the advanced amplifier, according to the present invention, is used for a system, which needs to be designed while considering a possible occurrence of power leakage between adjacent channels, the impedance matching circuits have to be designed so that the maximum operational efficient can be provided under the format such that the transmission signal falls within an allowable range of signal distortion.

According to the CDMA (Code Division Multiple Access)/cellular telephone system, the transmission power levels ranging from + 10 dBm to + 15 dBm are frequently used. Therefore, the allowable consecutive telephone call time and other related catalogue Specifications are decided according to the transmission power levels.

Also, the advanced amplifier, according to the present invention, can be very effectively used for the CDMA/cellular telephone system, since the CDMA/cellular telephone system requires the following capabilities: a maximum output power level ranging from approximately + 27 dBm to + 30 dBm; an improved, maximum operational efficiency at the maximum output power level; and an improved, operational efficiency at the level ranging from + 10 dBm to + 15 dBm.

### (Fourth embodiment)

Next, the outline of a cellular telephone 200, according to the fourth embodiment of the present invention will be described while referencing Fig. 6. It is noted that the same functional elements as those in Figs. 5 and 7 are assigned the same reference numerals in this figure.

In Fig. 6, either the transmission circuit 100 of the second embodiment in Fig. 5 or the 200 of the fifth embodiment in Fig. 7, which is described later, is used for the cellular telephone 200. A transmission signal is modulated by a base band unit 107 into corresponding transmissible frequencies of signal 111, which then enters the variable gain amplifier 2 in the transmission circuit 100. The transmission circuit 100 then amplifies the modulated signal 111, and outputs the resulting amplified signal 110 in the same manner as above. The resultant amplified signal 110 then enters an isolator 101, which generates an electrically isolated signal corresponding to the amplified signal 110, and outputs it to a switch 102, which changes over the two routes: one that is from the isolator 101 to the antenna 102 for signal transmission; the other that is from the antenna 102 to a low noise amplifier 104 for signal reception. The isolated signal is then transmitted through the air by an antenna 102. Upon reception of a signal from a base station (not shown in the figure) by the antenna 102, the received signal is transmitted to the low noise amplifier 104 via the switch 103. The low noise amplifier 104 amplifies the received signal, and outputs the resulting amplified signal to a mixer 105. The mixer 105 mixes the amplified signal with a certain frequency reference signal into an intermediate-frequency radio signal. A demodulator 109 demodulates the intermediate-frequency radio signal, and outputs the resulting demodulated signal to the base band unit 107. The demodulator 109 also is comprised of a RSSI (not shown in the figure), which detects the strength of the demodulated signal and then outputs a resulting RSSI output signal 109 to the controller 6 in the transmitting circuit 100 (or 150).

### (Fifth embodiment)

Next, a transmission circuit 150, according to the fifth embodiment of the present invention, will be described while referencing Fig. 7. Fig. 7 illustrates the configuration of the transmission circuit 150, which is used for a dual band (i.e., a dual mode system) /cellular system. The same functional elements in Fig. 7 as those in the other figures are assigned the same reference numeral.

The transmission circuit of the fifth embodiment in Fig. 7 is different from the configuration of the third embodiment as shown in Fig. 5, in that the fifth embodiment additionally has a switch 16, which switches the output of the advanced amplifier 1 to either the directional coupler 3 or an impedance matching circuit 17. The switch 16 is made of, for example, an SPDT (single-pole, dual throw) -type switch.

A directional coupler 18, which transmits a part being approximately one one-hundredth (10⁻²) the output power level like the directional coupler 3 in Fig. 5 does, is arranged at the output side of the impedance matching circuit 17.

The transmission circuit 150 can operate in a higher operational efficiency than the conventional ones, when outputting low power levels which fall within a wide dynamic range of 30 dB or greater, or which are, in particular, approximately 20 dB lower than the maximum output level. Therefore, using the transmission circuit 150 for the portable terminals in wireless communication systems can provide a greater extended, allowable consecutive calling time than that of the conventional ones. In urban areas where the distance between adjacent base stations is short, the allowable calling time can be extended by approximately 30 % than it used to be.

Furthermore, the transmission circuit 150 can be used for conventional wireless communication systems, thus providing an extended, allowable consecutive calling time without changing a lot of structural elements and also without an increase in the number of hardware parts.

Next, the operation of the transmission circuit 150 used for the dual mode wireless communication systems such as the PDC (Personal Digital Cellular) system, which is one of the domestic Japanese digital wireless communication systems, and the PHS (Personal Handy-phone System), will be described while referencing Fig. 7.

According to the PDC system using a band of 900 MHz, the transmission frequencies ranging from 889 MHz to 960 MHz are used for its cellular telephones. On the other hand, according to the PDC system using a band of 1.5 GHz, the transmission frequencies ranging from 1429 MHz to 1453 MHz are used for its cellular telephones.

The PHS system uses the transmission and reception frequencies ranging from 1895 MHz to 1918 MHz. Optimal impedance matching at the respective frequencies as described above is needed for the advanced amplifier 1 (or 50), according to the present invention.

The PDC system requires the last amplifier to provide the maximum output level of approximately + 30 dBm, whereas the PHS requires it to provide that of approximately + 20 dBm. Accordingly, the variable gain amplifier 2 is designed to be a wide band amplifier that can normally operate for the bands ranging from a band of 900 MHz to a band of 1.9 GHz. As a result, it can have desired characteristics for the frequencies ranging from 889 MHz to 1920 MHz.

In the transmission circuit 150, the impedance matching circuits 12 and 13 (see Figs. 1 and 3) of the advanced amplifier 1 (or 50) impedance-matches for the frequencies ranging from 889 MHz to 960 MHz and also from 1429 MHz to 1453 MHz, so that the operational efficiency can be highest at the time of outputting its maximum power level while satisfying a certain allowable power leakage between adjacent channels.

The matching circuit 17 impedance-matches for the PHS operational frequencies ranging from 1895 MHz to 1918 MHz.

The switch 16 is, for example, a SPDT-type switch unit that can provide a small insertion loss and have a sufficient isolation characteristic at a frequency band ranging from approximately 900 MHz to approximately 2 GHz.

Upon reception of an electric wave, a signal is received within the service area of the PDC system from a base station, the controller 6 receives the information of the RSSI output signal 109 transmitted from the demodulator 106 in Fig. 6, reads out control information, which corresponds to the PDC system, from the ROM 7, and then outputs a resulting control signal to the voltage control circuit 8. Accordingly, the voltage control circuit then controls the switch 16 to connect the output of the advanced amplifier 1 to the directional coupler 3 so that a signal transmission route beginning at the advanced amplifier 1, moving to the switch 16, and then to the directional coupler 3 can be established. Incidentally, the APC of the fifth embodiment conducts in the same manner as that of the third embodiment, with the assistance of the feedback route: the wave detector 4, comparator 5, variable gain/voltage control circuit 10, AGC power supply 11, and then the variable gain amplifier 2.

When a cellular telephone comprised of the transmission circuit 150 nears a PDC base station, its output power level needs to be set to a low value ranging from + 12 dBm to + 13 dBm. At this time, the operational efficiency of the advanced amplifier 1 at the time of outputting a low power is improved by turning off the FET 15 (see Figs. 1 and 3), which is caused by changing the gate bias voltage V_{GG}. This operation is the same as that of the third embodiment.

When the wireless telephone described enters the PHS service area, the controller 6 receives the information of the RSSI output signal 109, reads out control information, which corresponds to the received information or the PHS related information, from the ROM 7, and then outputs a resulting control signal to the voltage control circuit 8. Accordingly, the voltage control circuit 8 controls the switch 16 to connect the advanced amplifier 1 to the matching circuit 17.

The output of the advanced amplifier 1, which is in a narrow PHS band ranging from 1895 MHz to 1918 MHz, is optimally impedance-matched by the matching circuit 17, and output to the directional coupler 18.

The directional coupler 18 then transmits a part one one-hundredth of the output power level transmitted from the matching circuit 17, to the wave detector 4. The signal processing after the wave detector 4 has conducted its own operation is the same as that of the third embodiment as shown in Fig. 5.

The usage of the advanced amplifier 1 (or 50 in Fig. 3) for the transmission circuit 150 of a wireless communication system allows the system to provide two types of services for the PDC and PHS systems with their respective independent frequencies. Besides, the mounting area of the transmission circuit 150 can be approximately halved in that of the conventional circuit. This is a great beneficial point in the manufacturing cost.

Furthermore, according to the transmission circuit 150, when it operates in the PDC system mode, its operational efficiency is improved at the time of outputting a low power level.

Up to this point, the dual bands structure for the PDC and PHS systems, according to the present invention, has been described. However, the present invention is not limited to this structure. The transmission circuit 150 can also be used for a dual band/cellular system such as European the GSM (Global System for Mobile) using a band of 900 MHz plus PCN (Personal Communication Network) system, and a triple band/wireless communication system such as the PCS (Personal Communication Service) system plus the above-mentioned two independent systems.

Moreover, the transmission circuit 150 can be used for the N-CDMA(IS-95)/dual band cellular system using bands of 800 MHz and 1.9 GHz, which are mainly represented by the CDMA-ONE system, and the third generation/cellular system such as the W-CDMA system, which is expected to be developed, and a dual band/cellular system utilizing both the conventional PDC system and W-CDMA system. This function can be provided by selecting and using an optimal combination of two or more types of FETs with different sizes and threshold voltages, in a similar manner to those of the first and second embodiments.

Incidentally, according to the present invention, the impedance matching circuits as described above can be used as they are, even if the effective gate lengths of the FETs comprising the advanced amplifier 1 or 50 are changed. This emanates from the fact that the input/output impedance of the devices is low enough to allow this.

Furthermore, in the first and second embodiments, the transistors used for the advanced amplifier are made up of FETs. However, the present invention is not limited to this. Each of the transistors can be naturally made up of either a bipolar transistor, a CMOS transistor, an NMOS transistor, a PMOS transistor, or a bi-CMOS transistor.

Furthermore, in the aforementioned embodiments, up to two output impedance matching circuits are arranged. However, the present invention is not limited to this. More than two output impedance matching circuits can be naturally arranged so as to amplify and transmit more than two different bands of signals dependent upon the RSSI output signal as described above.

An advanced amplifier, a transmission circuit and cellular telephone comprised thereof, according to the present invention, have been described in connection with several preferred embodiments. It is to be understood that the subject matter encompassed by the present invention is not limited to that specified embodiment. On the contrary, it is intended to include all alternatives, modifications, and equivalents as can be included within the spirit and scope of the following claims.

## Claims

1. An advanced amplifier, comprising:
a first transistor (14) with a first threshold; and
a second transistor (15) with a second threshold that is different from the said first threshold, and also with its control electrode being connected to the control electrode of the said first transistor.

2. The advanced amplifier, according to claim 1, wherein the said first (14) and the second transistor (15) simultaneously operate in vicinity of their saturated output levels at the time of outputting the maximum power level; the said first transistor (14) operating in the vicinity of the saturated output level, whereas the said second transistor (15) turns off at the time of outputting a low power level.

3. The advanced amplifier, according to claim 1, wherein the said first (14) and second transistors (15) are FETs (field-effect transistors), and the said control electrode is the gate electrode.

4. The advanced amplifier, according to claim 3, wherein the drain electrodes of the respective first and second transistors are connected to one another.

5. The advanced amplifier, according to claim 1, wherein the said first (14) and second transistors (15) are bipolar transistors, and the said control electrode is the base electrode.

6. The advanced amplifier, according to claim 1, wherein the said first (14) and second transistors (15) are made of a CMOS transistor, and the said control electrode is the gate electrode.

7. The advanced amplifier, according to claim 1, wherein the said first (14) and second transistors (15) are made of a bi-CMOS transistor, and the said control electrode is the gate electrode.

8. The advanced amplifier, according to claim 3, further comprising: an input impedance matching unit (12, C1) which is connected to the said gate electrodes of the said first and second transistors, and an output impedance matching unit (13, C2), which is connected to the drain electrodes of the respective first and second transistors.

9. The advanced amplifier, according to claim 1, wherein the said first transistor (14) is made up of a plurality of first sub-transistors with a third threshold; and the said second transistor (15) is made up of a plurality of second sub-transistors with a forth threshold; with all the control electrodes of the respective first and second sub-transistors being connected to one another.

10. The advanced amplifier, according to claim 9, wherein the said first and second sub-transistors are symmetrically arranged.

11. The advanced amplifier, according to claim 10, wherein the said first and second sub-transistors simultaneously operate in the vicinity of their saturated output levels at the time of outputting the maximum power level; the said first sub-transistors operating in the vicinity of their saturated output level, whereas the said second sub-transistors turns off at the time of outputting a low power level.

12. A transmission unit, which amplifies a signal and transmits it, comprising:
an amplifier (1), which is comprised of a first transistor (14) with a first threshold and a second transistor (15) with a second threshold that is different from the said first threshold and also with its control electrode being connected to the control electrode of the said first transistor; and
a controller (6, 7, 8, 9), which gives the control electrodes of the said first and second transistors a control signal (VGG) dependent upon a reception signal (109).

13. The transmission unit, according to claim 12, wherein the said first (14) and the second transistor (15) simultaneously operate in the vicinity of their saturated output levels at the time of outputting the maximum power level; the said first transistor (14) operating in the vicinity of the saturated output level, whereas the said second transistor (15) turns off at the time of outputting a low power level.

14. The transmission unit, according to claim 12, wherein the said controller (6, 7, 8, 9) further gives the drive electrodes of the respective first and second transistors a bias signal (V_{DD}) as well as gives the control electrodes of the said first and second transistors a control signal (V_{GG}) dependent upon a reception signal (109).

15. The transmission unit, according to claim 12, further comprising:
a plurality of impedance matching units (13, 17), each impedance-matching for a frequency band of outputs of the said amplifier (1); and
a controller (6, 7, 8, 16), which activates either one of the said plurality of impedance matching units (13, 17) dependent upon a reception signal (109).

16. A cellular telephone, comprising:
a reception unit (102, 103, 104, 105, 106), which receives a signal and measures its strength (109);
an amplifier (1), which is comprised of a first transistor (14) with a first threshold and a second transistor (15) with a second threshold that is different from the said first threshold and also with its control electrode being connected to the control electrode of the said first transistor; and
a controller (6, 7, 8, 9), which gives the control electrodes of the said first and second transistors a control signal (V_{GG}) dependent upon the said strength (109).

17. The cellular telephone, according to claim 16, further comprising:
a plurality of impedance matching units (13, 17), each impedance-matching for a frequency band of outputs of the said amplifier (1); and
a controller (6, 7, 8, 16), which activates either one of the said plurality of impedance matching units (13, 17) dependent upon the said strength (109).

18. The cellular telephone, according to claim 16, wherein the said frequency band is one of those used for the GSM (Global System for Mobile) standard, PCN (Personal Communication Network) standard, PCS (Personal Communication Service) standard, N-CDMA standard, W-CDMA standard, PDC (Personal Digital Cellular) standard, and PHS (Personal Handy-phone System).
